# EUROPEAN PATENT APPLICATION

(11) **EP 2 924 725 A1**
(43) Date of publication of application: **30.09.2015**
(21) Application number: 14161504.7
(22) Date of filing: 25.03.2014
(51) Int. Cl.: H01L 23/04, H01L 23/057, H01L 23/24

(54) **Electric module for subsea applications**

(71) Applicant: ABB Technology Ltd, 8050 Zürich (CH)
(72) Inventor: Bessire, Cedric, CH-4500 Solothurn (CH); Spindler, Christian, CH-8707 Uetikon am See (CH); Duran, Hamit, CH-5300 Turgi (CH); Schuderer, Juergen, CH-8047 Zürich (CH)
(74) Representative: Savela, Reino Aleksi

(57) **Abstract**

An electric module comprising a cover which is sealingly coupled to a substrate such that an enclosed space is defined by at least a portion of a first side of the substrate and the cover. At least one electric conductor, for conveying electrical power to or from at least one electrical component within the enclosed space, is arranged so as to extend between the enclosed space and an exterior of the electric module via the substrate. By arranging the at least one electric conductor so as to extend between the enclosed space and an exterior of the electric module via the substrate, an enclosure for accommodating the electrical component(s) which enclosure is liquid-impervious or even hermetic while allowing for current paths between the exterior of the electric module to the at least one electrical component within the enclosure, without requiring any electrical feed-throughs passing or going through the cover, may be facilitated or even enabled.

## Description

### TECHNICAL FIELD

The present invention generally relates to electric equipment. Specifically, the present invention relates to an electric module which includes at least one electrical component, which electric module may be submersible and suitable for use in for example in deep-water or subsea applications.

### BACKGROUND

A semiconductor element may require a casing or the like for example to facilitate or enable interconnecting several semiconductor elements, isolate from different potentials, protect the semiconductor element from environmental influences which may be detrimental to its operation, e.g. from contaminants such as moisture, gases or solid particles, reduce mechanical stresses, etc. This may for example apply to power semiconductor elements such as insulated-gate bipolar transistors (IGBTs) which may be employed e.g. as switching elements in various applications. According to one example, power semiconductor elements may be employed in frequency converters which may be used to drive motors in equipment such as pumps, compressors etc. Frequency converters in a medium voltage range and in high power range (about 0.1-100 MW) can be used to drive electric motors by controlling the speed and torque thereof.

Recently there has been a growing interest in submersible electric equipment, for example in electrical installations which may be arranged at seabed, or sea floor or ocean floor, locations, which may be at depths from a few tens of meters up to several kilometers or even more. Such interest has recently been growing for example in the oil and gas industry. Subsea oil and gas production may require electric equipment such as drilling motors, pumps, compressors, etc. At present such equipment is usually driven by means of frequency converters located above the sea or ocean level, e.g. arranged on platforms which may be floatable or fixed to the sea floor. In order to convey power from the frequency converters to subsea electric equipment so called umbilicals, or umbilical cables, are often used. By installing the required electric equipment, e.g. frequency converters and possibly other power electronic equipment, at underwater or subsea locations, the required amount of connections between topside installations and the underwater or subsea locations, as well as the amount of topside installations, could be reduced, which could enable significant savings in cost, e.g. in subsea oil and/or gas production, and/or reduction in complexity of the overall installation.

### SUMMARY

In order to realize or facilitate installation and operation of electric equipment, e.g. frequency converters or other power electronic equipment, at underwater or subsea locations, there has been proposed arrangements which allows for the pressure to which the electric equipment is subjected to is maintained at or substantially at atmospheric pressure. Such an arrangement may for example utilize submerged pressure vessels. According to another proposal, arrangements which passively pressurize the electric equipment at the underwater or subsea location to the hydrostatic pressure level of the surrounding water are utilized. The latter proposal may be realized by placing the electric equipment in a relatively thin-walled vessel which is filled with a dielectric liquid having a negligible compressibility. This approach may however require that the electric equipment is inherently pressure-tolerant and chemically resistant against the dielectric liquid over extended periods of time.

One example of electric equipment employed as e.g. frequency converter and which includes one or more power semiconductor elements is an IGBT module which includes one or more high-power IGBT(s) and diode(s) arranged within a housing. Such an IGBT module may be used in applications such as railway electric traction, renewable energy systems, industrial drives, etc. The housing in general includes a plastic casing or frame which accommodates the IGBT(s) and diode(s). Electrical feed-throughs, e.g. busbar connections, are usually arranged so as to extend through the casing or frame in a non-sealing manner, and so liquid may flow into the inner part of the housing if the IGBT module is submerged under water. In order to use such an IGBT module in liquid and high-pressurized environments, as may be the case if employed for example in a subsea frequency converter installation, modifications are required in order to protect the power semiconductor elements. It would for example be advantageous to have a liquid-impervious or even hermetic casing for accommodating the power semiconductor elements. However, as mentioned above, electrical feed-throughs are usually arranged in the lid in a non-sealing manner. Also, a casing or housing with hermetic or sealingly arranged electrical feed-throughs therethrough may become prohibitively brittle and/or unfeasibly expensive. To withstand pressures above atmospheric pressure a rigid housing may be employed. However, in high-pressure environments such as at subsea locations, a rigid housing capable of withstanding the ambient pressure might be prohibitively expensive. In order for a power electronic circuit to be operable in ambient pressures at subsea locations such as at depths of up to several thousand meters, the power electronic circuit might have to be enclosed in some uncompressible and insulating material to protect the components both against mechanical damage and against flashover due to electric voltage differences.

In view of the above discussion, a concern of the present invention is to provide an electric module having an enclosure for accommodating electrical component(s) and having current path(s) between the exterior of the electric module to the electrical component(s) within the enclosure, which electric module is arranged so as to provide protection for the electrical component(s), e.g. including power semiconductor element(s), from environmental influences which may be detrimental to its/their operation.

A further concern of the present invention is to provide an electric module having an enclosure for accommodating electrical component(s) and having current path(s) between the exterior of the electric module to the electrical component(s) within the enclosure, which enclosure is liquid- or fluid-impervious or even hermetic.

A further concern of the present invention is to provide an electric module having an enclosure for accommodating electrical component(s) and having current path(s) between the exterior of the electric module to the electrical component(s) within the enclosure, which electric module can be satisfactorily operated, e.g. within nominal operational parameters or without breaking down, in environments having relatively high pressure, e.g. at subsea locations.

To address at least one of these concerns and other concerns, an electric module in accordance with the independent claim is provided. Preferred embodiments are defined by the dependent claims.

According to an aspect, there is provided an electric module, or housing, comprising a substrate having a first side which is configured to support at least one electrical component. The electric module comprises a cover which is sealingly coupled to the substrate such that an enclosed space is defined by at least a portion of the first side of the substrate and the cover. The electric module comprises at least one electric conductor for conveying electrical power to or from the at least one electrical component. The at least one electric conductor is arranged so as to extend between the enclosed space and an exterior of the electric module via the substrate.

The at least one electric conductor may be arranged such that it, possibly in cooperation with the substrate and/or other components of the electric module, conveys electrical power to or from the at least one electrical component.

The at least one electrical component may for example be directly arranged on the first side of the substrate or a portion thereof, or indirectly arranged on the first side of the substrate or a portion thereof via one or several intermediate components.

By arranging the at least one electric conductor so as to extend between the enclosed space and an exterior of the electric module via the substrate, an enclosure for accommodating the electrical component(s) which is liquid-impervious or even hermetic, while allowing for current paths between the exterior of the electric module to the at least one electrical component within the enclosure, may be facilitated or even enabled. This may be facilitated or enabled possibly without requiring any electrical feed-throughs passing or going through the cover. As mentioned above, a casing or housing with hermetic or sealingly arranged electrical feed-throughs therethrough may become prohibitively brittle and/or unfeasibly expensive. By arrangement of the at least one electric conductor so as to extend between the enclosed space and an exterior of the electric module via the substrate, hermetic or sealingly arranged electrical feed-throughs through the cover may not be required at all, or be required only to a relatively small extent.

The at least one electrical component may for example include or be based on, or be selected from, an IGBT, a metal-oxide semiconductor field effect transistor (MOSFET), an integrated gate-commutated thyristor (IGCT) and/or a gate turn-off thyristor (GCT). However, embodiments of the present invention encompass in principle any type of electrical component, for example power semiconductor elements such as one or more of thyristors, bipolar transistors, diodes, etc. This list is not exhaustive.

Although embodiments of the present invention are described herein with reference to underwater or subsea applications, i.e. for use in underwater or subsea locations, it is to be understood that embodiments of the present invention may find use in other applications where electrical components such as power semiconductor elements may be needed. Non-limiting examples of such other applications may include liquid or oily environments such as within oil-filled transformers employing so called transformer oil or insulating oil. Transformer oil or insulating oil may be used also in high voltage capacitors, fluorescent lamp ballasts, high voltage switches, circuit breakers, etc., where embodiments of the present invention are contemplated to be useful. Another non-limiting example of such other applications is in the automotive industry. It is contemplated an electric module according to embodiments of the present invention may facilitate or even enable arranging power electronics or power semiconductors relatively close to an electrical engine or inside a casing or an electrical engine in an electrical vehicle or hybrid vehicle, which may be desired or even required in some circumstances or scenarios.

By the at least one electric conductor extending between the enclosed space and an exterior of the electric module via the substrate, it is meant that the at least one electric conductor extends between the enclosed space and an exterior of the electric module by going through the substrate, or by way of the substrate, and/or by means of the substrate.

As discussed above, by arranging the at least one electric conductor so as to extend between the enclosed space and an exterior of the electric module via the substrate, arrangement of electrical feed-throughs through the cover may not be required and hence a casing or housing for accommodating the electrical component(s) which is liquid-impervious or even hermetic may be facilitated or even enabled. The electric module may for example be arranged so as to be submersible. Arranging the at least one electric conductor so as to extend between the enclosed space and an exterior of the electric module via the substrate may be carried out in several ways according to different embodiments of the present invention, and it is to be understood that the present encompasses all such arrangements of the at least one electric conductor by which a casing or housing for accommodating the electrical component(s) which is liquid-impervious or even hermetic can be facilitated or even enabled. According to an example, at least a portion of the at least one electric conductor may be integrally arranged within the substrate. In alternative or in addition, at least a portion of the at least one electric conductor may be at least partly embedded into the substrate. In alternative or in addition, at least a portion of the at least one electric conductor may be arranged on or coupled to the first side of the substrate. The enclosed space may be defined further by at least a portion of the at least one electric conductor.

The cover may be arranged over at least a first portion of the first side of the substrate. According to such a configuration, the cover, and so the enclosed space, may not extend over the entire substrate of the electric module when viewed from the above.

The at least one electric conductor may be integrally arranged within the substrate such that the at least one electric conductor extends within the substrate between the first portion and at least a second portion of the first side of the substrate. The second portion may be different from the first portion of the first side of the substrate. For example, the at least one electric conductor may extend from a location within the enclosed space and into the substrate, where the at least one electric conductor extends along a path within the substrate, and exits the substrate at a portion of the first side of the substrate, which portion is outside a boundary of the cover of the electric module when viewed from the above. The portion of the at least one conductor outside the boundary of the cover of the electric module when viewed from the above can be utilized for example for connecting the electric module to an electric terminal, a power source, another electric module and/or another electrical component, etc.

According to another embodiment of the present invention, the at least one electric conductor may be embedded into the substrate such that the at least one electric conductor embedded into the substrate extends between the first portion and at least a second portion of the first side of the substrate. The second portion may be different from the first portion of the first side of the substrate. For example, the at least one electric conductor may extend from a location within the enclosed space along a path ending at a portion of the first side of the substrate, which portion is outside a boundary of the cover of the electric module when viewed from the above. The portion of the at least one conductor outside the boundary of the cover of the electric module when viewed from the above can be utilized for example for connecting the electric module to an electric terminal, a power source, another electric module and/or another electrical component, etc.

According to another embodiment of the present invention, at least a portion of the at least one electric conductor may be arranged on the first side of the substrate such that the portion of the at least one electric conductor which is arranged on the first side of the substrate extends between the first portion and at least a second portion of the first side of the substrate. The second portion may be different from the first portion of the first side of the substrate. For example, the at least one electric conductor may extend from a location within the enclosed space along a path ending at a portion of the first side of the substrate, which portion is outside a boundary of the cover of the electric module when viewed from the above. The portion of the at least one conductor outside the boundary of the cover of the electric module when viewed from the above can be utilized for example for connecting the electric module to an electric terminal, a power source, another electric module and/or another electrical component, etc.

An electrically insulating fluid or gel, such as for example a dielectric fluid or gel, may be included within the enclosed space. The electrically insulating fluid or gel may be at least partly surrounding the at least one electrical component. The dielectric gel may for example include or be constituted by a silicone gel or a similar material for providing dielectric insulation e.g. of the at least one electrical component. According to other examples, the dielectric fluid or liquid may in alternative or in addition comprise a mineral oil, organic esters and/or a synthetic oil. By at least partly surrounding the at least one electrical component with electrically insulating fluid or gel such as a dielectric fluid or gel, for example silicone gel or silicone oil, operation of the at least one electrical component at high pressures, e.g. at ambient pressures at subsea locations, may be facilitated or even enabled. The electrically insulating fluid or gel may protect the at least one electrical component against mechanical damage, flashover due to electric voltage differences, etc. The electrically insulating fluid or gel may also act as a heat-spreading medium for dissipation of heat generated by the at least one electrical component resulting from operation thereof. Preferably the electrically insulating fluid or gel should be selected such that it has no or few contaminations or unwanted substances, a predictable and/or stable structure, and/or unlikely to cause any chemical reactions with other substances that may be located within the enclosed space.

For example in subsea applications, the electric module may be arranged or located within a container, tank, or the like, which may be relatively thin-walled, e.g. a stainless steel tank, in which the electric module is at least partly surrounded by an electrically insulating fluid or a dielectric fluid which may have a negligible compressibility. As mentioned above, an electrically insulating fluid, or an electrically insulating gel, such as for example a dielectric fluid, or a dielectric gel, may be included within the enclosed space. The electrically insulating fluid or dielectric fluid which is at least partly surrounding the electric module may be different or the same as an electrically insulating fluid or dielectric fluid included within the enclosed space in the electric module. The electrically insulating fluid or dielectric fluid which is at least partly surrounding the electric module may for example include one or more of transformer oil, mineral oil, organic esters, and synthetic oil.

The cover may comprise at least one flexible element which may be arranged so as permit change in the volume of the enclosed space. This may provide a capability to enlarge or decrease the volume of the enclosed space due to external or internal influences. This may allow for example for transfer of hydrostatic pressure exerted by liquid surrounding the electric module to the at least one electric component without the liquid coming into contact with the at least one electric component.

The at least one flexible element may be arranged so as permit change in the volume of the enclosed space in response to e.g. any thermal expansion of the electrically insulating fluid or gel that may occur. In alternative or in addition, the at least one flexible element may be arranged so as permit change in the volume of the enclosed space in response to any change in exterior pressure to which the electric module may be subjected.

The at least one flexible element may according to embodiments be arranged or selected in several different ways, and it is to be understood that the present encompasses all such alternatives or options. The at least one flexible element may for example comprise a foil, e.g. a relatively thin layer of a material, such as, for example, a metallic foil, i.e. a relatively thin sheet of metal, which for example may be manufactured with a rolling mill machine. The foil may according to another example in addition or optionally comprise a polymer-based foil and/or a metal-coated polymer-based foil. In alternative or in addition, the at least one flexible element may for example comprise a plate which is arranged such that the sides thereof in response to applied pressure thereto curves inwards at least longitudinally. The pressure applied to a side of the plate may for example be exerted by liquid medium directly or indirectly contacting the side of the plate. According to another example, the at least one flexible element may for example comprise, in addition or optionally, at least one expansion joint, or movement joint. According to another example, the at least one flexible element may for example comprise, in addition or optionally, a spring and/or bellows based structure which by action of the spring(s) and/or bellow(s) permit change in the volume of the enclosed space in response to, e.g., any thermal expansion of the electrically insulating fluid or gel that may occur and/or any change in exterior pressure to which the electric module may be subjected. According to one example, the at least one flexible element may for example comprise, in addition or optionally, a plate or sheet or the like with at least one through-hole, where a bellow structure may be arranged in or fitted into the through-hole(s), which bellow structure permit change in the volume of the enclosed space in response to, e.g., any thermal expansion of the electrically insulating fluid or gel that may occur and/or any change in exterior pressure to which the electric module may be subjected. Other arrangements of the at least one flexible element are contemplated.

It is to be understood that the cover may be formed as a single unit or element, e.g. in a one-piece manner, or it may be composed of several units or elements which are coupled together.

For example, according to an embodiment of the present invention, the cover may comprise a frame to which the at least one flexible element may be coupled, e.g. in a sealing or liquid-impervious manner or even hermetically or substantially hermetically.

The frame may be rigid or substantially rigid. The frame may for example comprise a ceramic material.

In the context of embodiments of the present invention and in relation to components or constituents being coupled or connected to each other, the term coupled or connected is not limited to be construed as directly coupled or connected, or directly electrically connected, but also encompasses functional connections having intermediate components. For example, on one hand, if an output of a first component is connected to an input of a second component, this comprises a direct connection. On the other hand, if an electrical conductor directly supplies an electrical signal from an output of a first component substantially unchanged to an input of a second component, alternatively via one or more additional components, the first and second component are also connected. However, the connection is functional in the sense that a gradual or sudden change in the electrical signal from the output of the first component results in a corresponding or modified change in the signal that is input to the second component.

Further objects and advantages of the present invention are described in the following by means of exemplifying embodiments.

It is noted that the present invention relates to all possible combinations of features recited in the claims. Further features of, and advantages with, the present invention will become apparent when studying the appended claims and the following description. Those skilled in the art realize that different features of the present invention can be combined to create embodiments other than those described in the following.

### BRIEF DESCRIPTION OF THE DRAWINGS

Exemplifying embodiments of the invention will be described below with reference to the other accompanying drawings, in which:
Figure 1 is a schematic cross-sectional side view of an IGBT module according to an example.
Figures 2-4 are schematic cross-sectional side views of electric modules according to embodiments of the present invention.
Figure 5 is a conceptual perspective view of parts or portions of an electric module according to an embodiment of the present invention.
Figure 6 is a view of the electric module depicted in Figure 5 as viewed from the above.

In the accompanying drawings, the same reference numerals denote the same or similar elements throughout the views.

### DETAILED DESCRIPTION

The present invention will now be described hereinafter with reference to the accompanying drawings, in which exemplifying embodiments of the present invention are illustrated. The present invention may, however, be embodied in many different forms and should not be construed as limited to the embodiments set forth herein; rather, these embodiments are provided by way of example so that this disclosure will convey the scope of the invention to those skilled in the art. Furthermore, like numbers refer to like or similar elements or components throughout.

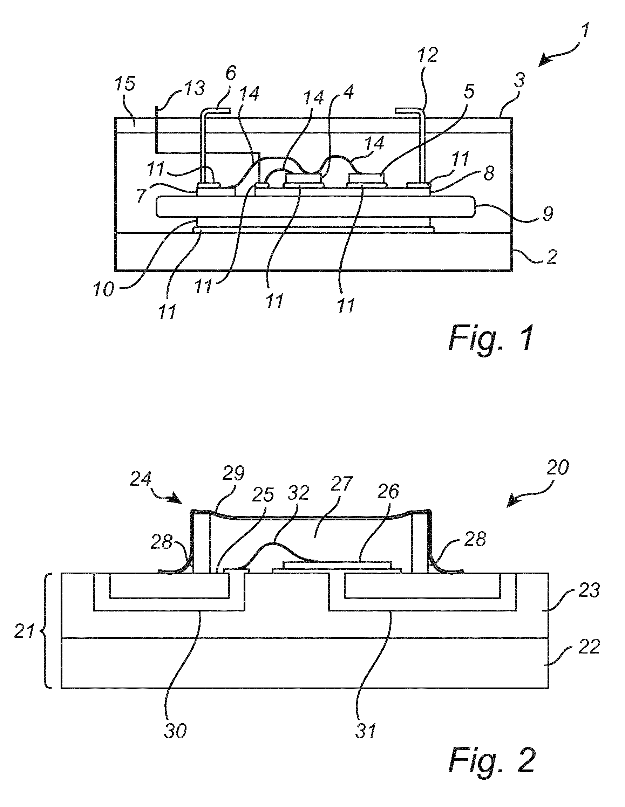

Referring now to Figure 1, there is shown a schematic cross-sectional side view of an IGBT module 1 according to an example. The IGBT module 1 may for example be employed as a frequency converter which may be used for example to drive motors in equipment such as pumps, compressors etc. The IGBT module 1 comprises a base plate or substrate 2, e.g. at least in part based on an AlSiC composite, i.e. a metal matrix composite comprising an aluminum matrix with silicon carbide particles, or based on another metal matrix composite. On the substrate 2 a casing 3 is arranged. The casing 3 may for example be made of a plastic material or another sufficiently rigid material. The substrate 2 and the casing 3 define an enclosure within which an IGBT 4 and a diode 5 are accommodated. The IGBT 4 and the diode 5 are coupled to a conducting layer 8, which in turn is coupled to a portion of an insulating layer 9. The IGBT 4 is connected to the diode 5, a gate electrode 13 and a conducting layer 7, which in turn is coupled to a different portion of the insulating layer 9 as compared to conducting layer 8. The connections between the IGBT 4 and the diode 5, the gate electrode 13 and the conducting layer 7 may for example as illustrated in Figure 1 be realized by means of wire bonding 14, e.g. made of Al, Cu and/or another metal. Electrical feed-throughs or busbar connections 6 and 12 are coupled to the conducting layers 7 and 8, respectively. Any one of the conducting layers 7, 8 may in principle include or be constituted by any suitable conducting material, for example a metal, an alloy, etc. The insulating layer 9 may in principle include or be constituted by any appropriate insulating material, for example a ceramic material such as aluminum nitride (AlN). The insulating layer 9 is in turn coupled to a conducting layer 10, which may be similar to any of the conducting layers 7, 8. The conducting layer 10 is in turn coupled to the base plate or substrate 2. The coupling or connections between the different elements in the IGBT module 1 as described in the foregoing may for example be realized by means of solder 11, such as illustrated in Figure 1, and/or by means of any other suitable coupling elements. An epoxy layer 15 may be arranged in contact with an upper, inner side of the casing 3 such as illustrated in Figure 1.

However, in an IGBT module 1 such as illustrated in Figure 1, the portion(s) of the casing 3 where the electrical feed-throughs or busbar connections 6, 12 extend through the casing 3 usually do not seal against the exterior of the IGBT module 1, and so liquid may flow into the inner part of the IGBT module 1 would be submerged under water. In order to use an IGBT module 1 such as illustrated in Figure 1 in a liquid and/or high-pressure environment, as may be the case if it would be employed in a subsea installation, it would have to be modified so as to be liquid-impervious or even hermetic. If the casing 3 would be arranged with hermetical electrical feed-throughs 6, 12 therethrough, the IGBT module 1 is expected to become prohibitively brittle and/or unfeasibly expensive.

Referring now to Figure 2, there is shown a schematic cross-sectional side view of an electric module 20 according to an embodiment of the present invention. The electric module 20 comprises a substrate 21, or main substrate 21, which according to the depicted embodiment of the present invention comprises a first substrate 22 and a second substrate 23 which are coupled together. The first substrate 22, or base plate, may for example be at least in part based on an AlSiC composite, and/or another metal matrix composite. The second substrate 23 may comprise an electrically insulating layer which in principle may include or be constituted by any appropriate insulating material, for example a ceramic material such as AlN.

The main substrate 21, or the second substrate 23 according to the depicted embodiment of the present invention, has a first side 25 which is configured to support at least one electrical component. In Figure 2, the at least one electrical component is generally indicated by the reference numeral 26.

The electric module 20 comprises a cover, which is generally indicated by reference numeral 24 in Figure 2. The cover 24 is sealingly coupled to the main substrate 21, or the second substrate 23 according to the depicted embodiment of the present invention, such that an enclosed space 27 is defined by at least a portion of the first side 25 of the main substrate 21 or second substrate 23 and the cover 24.

On the main substrate 21, or on the second substrate 23 according to the depicted embodiment of the present invention, a frame or casing 28 is arranged, which is included in the cover 24. The cover 24 further comprises a flexible element 29, which is arranged so as permit change in the volume of the enclosed space 27. According to the embodiment depicted in Figure 2, the flexible element 29 comprises a foil, for example including a relatively thin layer of a material such as for example a metal, or a polymer-based material foil possibly having a metal coating. The flexible element 29 is coupled to the frame 28. The flexible element 29 may be coupled to the frame 28 in a sealing or liquid-impervious manner or even in a hermetical or substantially hermetical manner. Depending for example on the materials used in the flexible element 29 and/or the frame 28, the flexible element 29 or foil may for example be glued or brazed onto the frame 28.

A metal-coated, polymer-based foil may have an inherent flexibility such that it may be arranged or coupled onto the frame 28 relatively easy. In case the flexible element 29 includes a metal foil, expansion joints or the like may possibly be used where the frame 28 is coupled to the flexible element 29 or foil so as allow for flexibility while ensuring a relatively high integrity of the foil.

The frame 28 may be rigid or substantially rigid, and may for example comprise a ceramic material.

According to the embodiment depicted in Figure 2 there is an electrically insulating fluid or gel in the form of a dielectric fluid or gel included within the enclosed space 27 and partly surrounding the at least one electrical component 26. The dielectric fluid or gel may for example include or be constituted by a silicone gel or a similar material for providing dielectric insulation e.g. of the at least one electrical component 26. By at least partly surrounding the at least one electrical component 26 with electrically insulating fluid or gel such as a dielectric fluid or gel operation of the at least one electrical component 26 at high pressures, e.g. at ambient pressures at subsea locations, may be facilitated or even enabled.

The flexible element 29 or foil is arranged so as permit change in the volume of the enclosed space 27 in response to for example thermal expansion of the electrically insulating fluid or gel and/or change in exterior pressure to which the electric module 20 is subjected.

The electric module 20 comprises two electric conductors 30, 31 for conveying electrical power to or from the at least one electrical component 26. Each of the electric conductors 30, 31 is arranged so as to extend between the enclosed space 27 and an exterior of the electric module 20 via the main substrate 21, or via the second substrate 23 according to the depicted embodiment of the present invention. According to the embodiment depicted in Figure 2, and as illustrated in Figure 2, each of the electric conductors 30, 31 is in part integrally arranged within the main substrate 21, or within the second substrate 23.

The electric module 20 may comprise fewer or more than two electric conductors.

As illustrated in Figure 2, each of the electric conductors 30, 31 may be integrally arranged within the main substrate 21, or second substrate 23, such that the electric conductor 30, 31 extends within the main substrate 21 or second substrate 23, from a location within the enclosed space 27 and into the main substrate 21 or second substrate 23 where the electric conductor 30, 31 extends along a path within the main substrate 21 or second substrate 23 and exits the main substrate 21 or second substrate 23 at a portion of the first side 25 of the main substrate 21, which portion is outside a boundary of the cover 24 of the electric module 20 when viewed from the above.

Within the enclosed space, the electric conductors 30, 31 may be electrically connected by means of for example bond wire 32 or the like. As illustrated in Figure 2, the electric conductor 30 and electric conductor 31 are electrically connected by means of bond wire 32 via the at least one electrical component 26.

By at least in part integrating electrical feed-throughs or electric conductors 30, 31 within the main substrate 21, or within the second substrate 23 according to the depicted embodiment of the present invention, which may be a relatively thick ceramic substrate e.g. comprising AlN, electrical breakdown in the second substrate 23 between the electric conductors 30, 31 and any other parts or portions of the electric module 20, such as, for example, the first substrate 22, may be mitigated or even eliminated.

Preferably, the main substrate 21, or the second substrate 23 according to the depicted embodiment of the present invention, within which electrical feed-throughs or electric conductors 30, 31 are at least in part integrated, should have no or at least few internal holes or void e.g. caused by the integrated electrical feed-throughs or electric conductors 30, 31. To this end, the substrate into which the electrical feed-throughs or electric conductors 30, 31 are to be integrated may be formed of two different substrates, which both may be electrically insulating, one into which the electrical feed-throughs or electric conductors 30, 31 are embedded, which is then flipped onto the other substrate, which two substrates may then be coupled or joined to each other so that in the resulting substrate formed by the two substrates the electrical feed-throughs or electric conductors 30, 31 are integrally arranged. Electrical connection into the enclosed space 27 may be realized, facilitated or implemented for example by means of at least one via or the like, which may be included in or be a part or portion of the electric conductors 30, 31.

Any heat generated by operation of the at least one electric component 26 may be transferred from the electric module 20 by way of the first substrate 22, or base plate, via the second substrate 23.

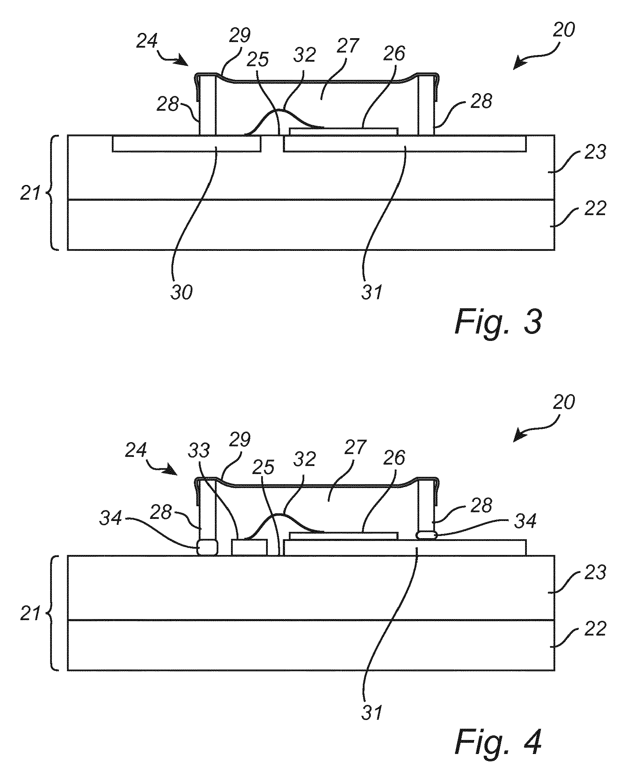

Referring now to Figure 3, there is shown a schematic cross-sectional side view of an electric module 20 according to another embodiment of the present invention. The electric module 20 depicted in Figure 3 is similar to the electric module 20 depicted in Figure 2. The same reference numerals in Figures 2 and 3 of the constituents or components of the electric module 20 denote substantially similar or the same constituents or components, which have substantially similar or the same function. The electric module 20 depicted in Figure 3 differs from the electric module 20 depicted in Figure 2 in the particular arrangement of the electric conductors 30, 31 so as to extend between the enclosed space 27 and an exterior of the electric module 20 via the main substrate 21.

With reference to Figure 3, the electric module 20 comprises two electric conductors 30, 31 for conveying electrical power to or from the least one electrical component 26. Each of the electric conductors 30, 31 is arranged so as to extend between the enclosed space 27 and an exterior of the electric module 20 via the main substrate 21, or via the second substrate 23 according to the depicted embodiment of the present invention. According to the embodiment depicted in Figure 3, and as illustrated in Figure 3, each of the electric conductors 30, 31 is embedded into the main substrate 21 or the second substrate 23, e.g. so as to form a 'track' on the first side 25 of the main substrate 21 or second substrate 23.

The electric module 20 may comprise fewer or more than two electric conductors.

As illustrated in Figure 3, each of the electric conductors 30, 31 may be embedded into the main substrate 21 or the second substrate 23 so as to extend from a location within the enclosed space 27 along a path ending at a portion of the first side 25 of the main substrate 21, which portion is outside a boundary of the cover 24 of the electric module 20 when viewed from the above.

The first side 25 of the main substrate 21 or second substrate 23 with the 'tracks' of electric conductors 30, 31 may form a uniform and/or smooth surface, or a substantially uniform and/or smooth surface, so as to facilitate or permit a relatively easy coupling of the frame 28 thereto.

In order to couple the frame 28 to the main substrate 21 or second substrate 23 in a sealing or even hermetic manner a so called glass-ceramic-to-metal seal may for example be employed. By the flexible element 29 or foil being arranged so as permit change in the volume of the enclosed space 27 in response to at least one of thermal expansion of the electrically insulating fluid or gel and/or change in exterior pressure to which the electric module 20 is subjected, any volume and pressure change may be transferred into the enclosed space 27 such that no or only relatively small forces will act on the glass link between the frame 28 and the main substrate 21 or second substrate 23, thereby ensuring stability of the electric module 20 in a high-pressure environment such as at subsea locations.

By embedding each of the electric conductors 30, 31 into the main substrate 21 or the second substrate 23, e.g. so as to form a 'track' on the first side 25 of the main substrate or second substrate 23, a less expensive construction may be achieved as compared to using two substrates, one into which electrical feed-throughs or electric conductors 30, 31 are embedded, and then flipping it onto the other substrate so as to form a substrate in which electrical feed-throughs or electric conductors 30, 31 are integrally arranged, as described in the foregoing with reference to Figure 2.

Any heat generated by operation of the at least one electric component 26 may be transferred from the electric module 20 by way of the first substrate 22, or base plate, via the second substrate 23.

Referring now to Figure 4, there is shown a schematic cross-sectional side view of an electric module 20 according to yet another embodiment of the present invention. The electric module 20 depicted in Figure 4 is similar to the electric module 20 depicted in Figure 2 or 3. The same reference numerals in Figures 2 or 3 and 4 of the constituents or components of the electric module 20 denote substantially similar or the same constituents or components, which have substantially similar or the same function. The electric module 20 depicted in Figure 4 differs from the electric module 20 depicted in Figure 2 and in Figure 3 in the particular arrangement of the electric conductor 31 so as to extend between the enclosed space 27 and an exterior of the electric module 20 via the main substrate 21.

With reference to Figure 4, the electric module 20 comprises an electric conductor 33 arranged on the first side 25 of the main substrate 21 or second substrate 23, and an electric conductor 31 for conveying electrical power to or from the least one electrical component 26. The electric conductor 31 is arranged so as to extend between the enclosed space 27 and an exterior of the electric module 20 via the main substrate 21, or via the second substrate 23 according to the depicted embodiment of the present invention. According to the embodiment depicted in Figure 4, and as illustrated in Figure 4, the electric conductor 31 is arranged on or coupled to the first side 25 of the main substrate 21 or second substrate 23.

Within the enclosed space, the electric conductors 31, 33 may be electrically connected by means of for example bond wire 32 or the like. As illustrated in Figure 4, the electric conductor 31 and electric conductor 33 are electrically connected by means of bond wire 32 via the at least one electrical component 26.

As illustrated in Figure 4, the electric conductor 31 may extend from a location within the enclosed space 27 along a path on the first side 25 of the main substrate 21 or second substrate 23, and end at a portion of the first side 25 of the main substrate 21 or second substrate 23, which portion is outside a boundary of the cover 24 of the electric module 20 when it is viewed from the above. According to the embodiment depicted in Figure 4, and as illustrated in Figure 4, the enclosed space 27 is defined further by a portion of the electric conductor 31, respectively.

The first side 25 of the main substrate 21 or second substrate 23 with the 'track' of electric conductor 31 arranged thereon may exhibit height differences over a longitudinal plane of the main substrate 21 or second substrate 23, or exhibit protruding structures on the first side 25 due to the 'track' of electric conductor 31 arranged thereon.

The frame 28 may be rigid or substantially rigid, and may for example comprise a polymer-based and/or ceramic material.

As illustrated in Figure 4, in order to couple the frame 28 to the main substrate 21 or second substrate 23 in a sealing or even hermetic manner, coupling means such as glue 34 or the like may be employed, which may account for the above-mentioned height differences or protruding structures.

A polymer employed in the frame 28 should preferably be chosen so as to be only relatively weakly permeable against any dielectric liquid environment of the electric module 20. The glue 34 or the like should preferably be chosen so as to be chemically and/or physically compatible with the dielectric liquid environment of the electric module 20 and/or any electrically insulating fluid or gel, e.g. a dielectric fluid or gel, included within the enclosed space 27.

By arranging the electric conductor 31 on the first side 25 of the main substrate 21 or second substrate 23, a less expensive construction may be achieved as compared to using two substrates, one into which electrical feed-throughs or electric conductors 30, 31 are embedded, and then flipping it onto the other substrate so as to form a substrate in which electrical feed-throughs or electric conductors 30, 31 are integrally arranged, as described in the foregoing with reference to Figure 2.

Any heat generated by operation of the at least one electrical component 26 may be transferred from the electric module 20 by way of the first substrate 22, or base plate, via the second substrate 23.

With reference to any one of the embodiments of the present invention described with reference to Figures 2-4, the flexible element 29 may in alternative or in addition to a foil comprise another element configured or arranged so as to permit change in the volume of the enclosed space 27, e.g. in response to thermal expansion of the electrically insulating fluid or gel and/or to change in exterior pressure to which the electric module 20 is subjected. For example, the flexible element 29 may comprise, in addition or optionally, a spring and/or bellows based structure which by action of the spring(s) and/or bellow(s) permit change in the volume of the enclosed space 27, and/or a plate or sheet or the like which is arranged such that the sides thereof in response to applied force or pressure thereto curves inwards at least longitudinally.

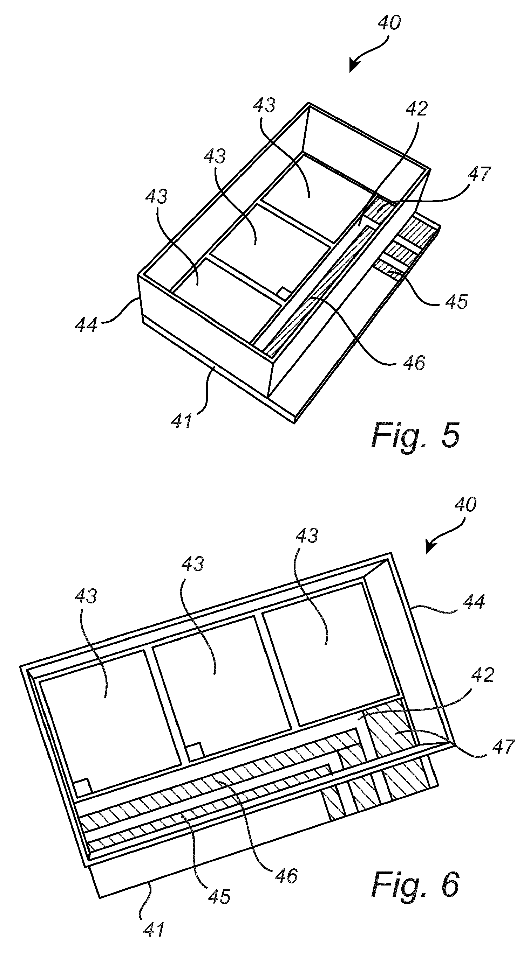

Referring now to Figure 5, there is shown a conceptual perspective view of parts or portions of an electric module 40 according to an embodiment of the present invention, which is substantially in accordance with the embodiment described in the foregoing with reference to Figure 3. Figure 6 is a schematic view of the parts or portions of the electric module 20 depicted in Figure 5, as viewed from the above.

With reference to Figures 5 and 6, the electric module 40 comprises a substrate 41 having a first side 42 configured to support three electrical components 43. The number of electrical components 43 depicted in Figures 5 and 6 is according to an example. The electric module 40 may include in principle any integer number of electrical components, e.g. including semiconductor elements and/or power semiconductors.

Similarly as illustrated in Figures 2-4, the substrate 41 may for example comprise a first substrate and a second substrate which are coupled together. The first substrate, or base plate, may for example be at least in part based on an AlSiC composite, and/or another metal matrix composite. The second substrate may comprise an insulating layer which in principle may include or be constituted by any appropriate insulating material, for example a ceramic material such as AlN. The second substrate may include the first side 42 of the substrate 41. The substrate 41 may according to other embodiments of the present invention comprise a single substrate, or even three or more substrates coupled together.

The electric module 40 comprises a frame 44 coupled to the first side 42 of the substrate 41. The frame 44 may be sealingly coupled to the first side 42 of the substrate 41. In order to couple the frame 44 to the substrate 41 or first side 42 thereof in a sealing or even hermetic manner a so called glass-ceramic-to-metal seal may for example be employed.

A flexible element (not shown in Figures 5 and 6) may be coupled to the frame 44 so as to at least in part form a cover (not shown in Figures 5 and 6), such that an enclosed space is defined by at least a portion of the first side 42 of the substrate 41 and the cover. The flexible element may for example be similar to or the same as the flexible element described with reference to any one of Figures 2-4. The flexible element can be arranged so as permit change in the volume of the enclosed space, and may for example comprise a foil, for example including a relatively thin layer of a material such as for example a metal, or a polymer-based material foil possibly having a metal coating.

According to the embodiment of the present invention depicted in Figures 5 and 6, the electrical components 43 comprise three semiconductor elements, for example two IGBT elements or chips with a gate connection, and one corresponding anti-parallel diode.

The electric module 40 comprises three electric conductors 45, 46, 47 for conveying electrical power to or from the electrical components 43. Each of the electric conductors 45, 46, 47 is arranged so as to extend between the enclosed space and an exterior of the electric module 40 via the substrate 41. According to the embodiment depicted in Figures 5 and 6, and as illustrated in Figures 5 and 6, each of the electric conductors 45, 46, 47 is embedded into the substrate 41 e.g. so as to form a 'track' on the first side 42 of the substrate 41.

Within the enclosed space the electric conductors 45, 46, 47 may be electrically connected by means of for example bond wire or the like (not shown in Figures 5 and 6). Any of the electrical components 43 may be electrically connected to the electric conductors 45, 46, 47 by means of for example bond wire or the like (not shown in Figures 5 and 6).

As illustrated in Figures 5 and 6, outside the frame 44 any of the electric conductors 45, 46, 47 may be connected for example with terminal(s) of some other electric module or another electrical component or element.

An electrically insulating fluid or gel, e.g. a dielectric fluid or gel, may be included within the enclosed space, which electrically insulating fluid or gel may at least partly surround the electrical components 43. The dielectric fluid or gel may for example include or be constituted by a silicone gel or a similar material for providing dielectric insulation e.g. of the electrical components 43. By at least partly surrounding the electrical components 43 with electrically insulating fluid or gel such as a dielectric fluid or gel, operation of the electrical components 43 at high pressures, e.g. at ambient pressures at subsea locations, may be facilitated or even enabled.

In conclusion, there is disclosed an electric module comprising a cover which is sealingly coupled to a substrate such that an enclosed space is defined by at least a portion of a first side of the substrate and the cover. At least one electric conductor, for conveying electrical power to or from at least one electrical component within the enclosed space, is arranged so as to extend between the enclosed space and an exterior of the electric module via the substrate. By arranging the at least one electric conductor so as to extend between the enclosed space and an exterior of the electric module via the substrate, an enclosure for accommodating the electrical component(s) which enclosure is liquid-impervious or even hermetic while allowing for current paths between the exterior of the electric module to the at least one electrical component within the enclosure, without requiring any electrical feed-throughs passing or going through the cover, may be facilitated or even enabled.

While the present invention has been illustrated and described in detail in the appended drawings and the foregoing description, such illustration and description are to be considered illustrative or exemplifying and not restrictive; the present invention is not limited to the disclosed embodiments. Other variations to the disclosed embodiments can be understood and effected by those skilled in the art in practicing the claimed invention, from a study of the drawings, the disclosure, and the appended claims. The mere fact that certain measures are recited in mutually different dependent claims does not indicate that a combination of these measures cannot be used to advantage.

## Claims

1. An electric module (20; 40) comprising:
a substrate (21; 22, 23; 41) having a first side (25; 42) configured to support at least one electrical component (26; 43);
a cover (24, 28, 29) sealingly coupled to the substrate such that an enclosed space (27) is defined by at least a portion of the first side of the substrate and the cover; and
at least one electric conductor (30, 31; 45, 46, 47) for conveying electrical power to or from the at least one electrical component;
wherein the at least one electric conductor is arranged so as to extend between the enclosed space and an exterior of the electric module via the substrate.

2. An electric module according to claim 1, wherein at least a portion of the at least one electric conductor is integrally arranged within the substrate.

3. An electric module according to claim 1 or 2, wherein at least a portion of the at least one electric conductor is at least partly embedded into the substrate.

4. An electric module according to claim 1, 2 or 3, wherein at least a portion of the at least one electric conductor is arranged on the first side of the substrate.

5. An electric module according to claim 4, wherein the enclosed space is defined further by at least a portion of the at least one electric conductor.

6. An electric module according to any one of claims 1-5, wherein the cover is arranged over at least a first portion of the first side of the substrate.

7. An electric module according to claim 6 as dependent on claim 2, wherein the at least one electric conductor is integrally arranged within the substrate such that the at least one electric conductor extends within the substrate between the first portion and at least a second portion of the first side of the substrate, the second portion being different from the first portion of the first side of the substrate.

8. An electric module according to claim 6 as dependent on claim 3, wherein the at least one electric conductor is embedded into the substrate such that the at least one electric conductor embedded into the substrate extends between the first portion and at least a second portion of the first side of the substrate, the second portion being different from the first portion of the first side of the substrate.

9. An electric module according to claim 6 as dependent on claim 4 or 5, wherein at least a portion of the at least one electric conductor is arranged on the first side of the substrate such that the at least one electric conductor arranged on the first side of the substrate extends between the first portion and at least a second portion of the first side of the substrate, the second portion being different from the first portion of the first side of the substrate.

10. An electric module according to any one of claims 1-9, further comprising:
an electrically insulating fluid or gel included within the enclosed space, the electrically insulating fluid or gel at least partly surrounding the at least one electrical component.

11. An electric module according to any one of claims 1-10, wherein the cover comprises at least one flexible element (29) arranged so as to permit change in the volume of the enclosed space.

12. An electric module according to claim 11 as dependent on claim 10, wherein the at least one flexible element is arranged so as to permit change in the volume of the enclosed space in response to at least one of thermal expansion of the electrically insulating fluid or gel and change in exterior pressure to which the electric module is subjected.

13. An electric module according to claim 11 or 12, wherein the at least one flexible element comprises:
a metallic foil;
a polymer-based foil;
a metal-coated polymer-based foil;
at least one expansion joint; and/or
a plate arranged such that the sides of which in response to applied pressure thereto curves inwards at least longitudinally.

14. An electric module according to any one of claims 11-13, wherein the cover comprises a frame (28; 44) to which the at least one flexible element is coupled.
